**Europäisches Patentamt**

**European Patent Office**

**Office européen des brevets**

(11) Numéro de publication : **0 461 054 A1**

(12) # DEMANDE DE BREVET EUROPEEN

(21) Numéro de dépôt : **91430010.8**

(51) Int. Cl.⁵ : **H02H 9/02**

(22) Date de dépôt : **05.06.91**

(30) Priorité : **06.06.90 FR 9007254**

(43) Date de publication de la demande :
**11.12.91 Bulletin 91/50**

(84) Etats contractants désignés :
**BE CH DE ES FR GB IT LI NL**

(71) Demandeur : **MATTHELEC MEDITERANNEE**
**Z.I.**
**F-34270 Saint-Mathieu-de-Treviers (FR)**

(72) Inventeur : **Brun, Patrick**
**4, rue du Fanabrégou**
**F-34980 Montferrier sur Lez (FR)**
Inventeur : **Wojciechowski, Michel**
**Quartier de la Coopérative**
**F-34270 Claret (FR)**

(74) Mandataire : **Moretti, René et al**
**c/o Cabinet BEAU DE LOMENIE**
**"Prado-Mermoz" 232, Avenue du Prado**
**F-13008 Marseille (FR)**

(54) Procédé et dispositif de limitation de surintensités dans un circuit électrique.

(57) La présente invention est relative à un procédé et à un dispositif de limitation des surintensités dans un circuit électrique alimentant une charge.

Un dispositif selon l'invention, comporte au moins un premier ensemble comprenant un transistor (T4) à effet de champ, de type MOS à grille isolée, et une résistance (R6) de source, lequel ensemble est monté en série avec la charge (7), et au moins un générateur (1) de tension continue et constante, dont la borne positive est connectée à ladite grille isolée dudit transistor et dont la borne négative est connectée à la borne (8) de ladite résistance de source qui n'est pas connectée à la source dudit transistor, lequel générateur délivre une tension telle que, en régime normal, ledit transistor fonctionne au voisinage du point de transition de sa courbe caractéristique.

Le domaine technique de l'invention est celui de l'alimentation électrique des appareils domestiques et industriels comportant une charge inductive.

EP 0 461 054 A1

Jouve, 18, rue Saint-Denis, 75001 PARIS

FIG. 1

La présente invention est relative à un procédé et à un dispositif de limitation des surintensités dans un circuit électrique alimentant une charge.

L'invention est plus particulièrement destinée aux circuits électriques alimentant une charge ayant une composante inductive ou selfique et plus généralement, les charges qui sont telles qu'une variation brutale de leur tension d'alimentation, par exemple lors de la mise sous tension de ces charges, ou en cas d'apparition de phénomènes dites de micro-coupures dans la tension d'alimentation, provoque une variation brutale et de grande amplitude de l'intensité absorbée par ces charges. Ce phénomène bien connu se produit notamment au démarrage ou lors de micro-coupures, pour des charges usuelles dans beaucoup d'appareils électriques, principalement constitués par, ou comportant un moteur, un transformateur, etc...

Il est connu pour ce type d'appareils électriques, que lors de la mise sous tension pour le démarrage par exemple, l'intensité absorbée est très supérieure à l'intensité nominale de ces moteurs ou transformateurs, cette intensité de démarrage pouvant dépasser dix fois l'intensité nominale.

Ces phénomènes connus posent un problème pour le choix des organes de protection de ces appareils tels que disjoncteurs, particulièrement; en effet, on est alors obligé de choisir des disjoncteurs dont l'intensité nominale dépasse l'intensité nominale absorbée par ces appareils électriques; par ailleurs, malgré le surdimensionnement des disjoncteurs par rapport aux caractéristiques de l'appareil qu'ils doivent protéger, les caractéristiques de ces disjoncteurs sont telles qu'ils ne supportent pas en cas de démarrages successifs et/ou de micro-coupure de l'alimentation, les surintensités répétées qui résultent de ces variations de tension, du fait du caractère inductif de la charge que représente ledit appareil.

Par ailleurs, le surdimensionnement des disjoncteurs habituellement utilisés pour la protection de ces appareils, entraîne un surcoût important au niveau du matériel (disjoncteur lui-même, câbles d'alimentation etc...), mais entraîne également un surcoût dans le dimensionnement des appareils situés en amont de ces disjoncteur, et parallèlement un surcoût dû à l'application des tarifs des sociétés de distribution d'électricité, dont la base de facturation dépend généralement des intensités (ou des puissances) nominales des appareils de protection.

De nombreux appareils connus permettent de remédier partiellement à ces inconvénients, mais ils entraînent encore un surcoût non négligeable. Il s'agit notamment d'appareils de limitation du courant de démarrage de moteurs.

Le brevet français FR. 2.401.545 décrit et revendique un branchement pour limiter le courant de démarrage d'un moteur universel, branchement comportant un commutateur qui, dans une position de démarrage, incorpore dans le circuit du moteur un circuit de limitation du courant, branchement tel que le circuit de limitation du courant comporte un dispositif redresseur à semi-conducteur, susceptible d'être commandé, un circuit de commande étant prévu à l'aide duquel ce dispositif redresseur à semi-conducteur est susceptible d'être bloqué dans chaque alternance de la tension d'alimentation, au moins jusqu'à l'apparition du maximum de tension.

L'examen de ces dispositifs montrent que ceux-ci, qui sont temporairement branchés en série avec la charge, lors du démarrage, agissent par le blocage ou la coupure de l'alimentation pendant une partie de chaque alternance de la tension d'alimentation; il est clair que ces dispositifs, qui nécessitent l'emploi d'un contacteur à trois positions, engendrent de nombreuses distorsions dans le courant et la tension d'alimentation de la charge; par ailleurs, ces dispositifs sont inopérants lors d'apparition de micro-coupures dans l'alimentation.

Il existe également de nombreux systèmes de protection des appareils électriques contre les micro-coupures, notamment les onduleurs; ces appareils très complexes et coûteux permettent, dans certains cas, de supprimer les micro-coupures, en utilisant par exemple l'énergie électrique reçue pour charger un accumulateur et en générant à partir de la tension disponible dans l'accumulateur, une énergie électrique sous la forme voulue, en principe exempte de micro-coupures.

Le problème posé consiste donc à procurer un procédé et un dispositif de limitation des surintensités dans un circuit électrique alimentant une charge, fiable, simple, peu couteux, qui agisse aussi bien lors de la mise sous tension de la charge que lors d'apparition de micro-coupures, et ceci sans provoquer d'interruption dans l'alimentation de ladite charge.

Une solution au problème posé consiste à mettre en oeuvre un procédé de limitation des surintensités dans un circuit électrique alimentant une charge, qui comporte les opérations suivantes :

    – on monte en série avec ladite charge, au moins un transistor à effet de champ, de type MOS à grille isolée, et au moins une résistance de source,

    – on applique entre ladite grille isolée dudit transistor et la borne de ladite résistance de source, qui n'est pas connectée à ladite source dudit transistor, une tension continue constante, telle que, en régime normal, ledit transistor fonctionne au voisinage du point de transition de sa courbe caractéristique, de telle sorte que, lorsque l'intensité absorbée par ladite charge dépasse une valeur de seuil, ledit transistor passe automatiquement en régime de fonctionnement ohmique, sa résistance interne croît, ce qui limite l'augmentation de ladite intensité.

Un dispositif permettant de mettre en oeuvre ce procédé, de limitation des surintensités dans un circuit électrique alimentant une charge, répond au problème posé, qui comporte, d'une part :

- au moins un premier ensemble comprenant un transistor à effet de champ, de type MOS à grille isolée, et une résistance de source, dont une borne est reliée à la source dudit transistor, lequel ensemble est monté en série avec ladite charge, et, d'autre part,
- au moins un générateur de tension continue et constante, dont la borne positive est connectée à ladite grille isolée dudit transistor et dont la borne négative est connectée à la borne de ladite résistance de source qui n'est pas connectée à ladite source dudit transistor, lequel générateur délivre une tension telle que, en régime normal, ledit transistor fonctionne au voisinage du point de transition de sa courbe caractéristique, de telle sorte que, lorsque l'intensité absorbée par ladite charge dépasse une valeur de seuil, ledit transistor passe automatiquement en régime de fonctionnement ohmique, sa résistance interne croît, ce qui limite l'augmentation de ladite intensité absorbée par ladite charge.

Avantageusement, le potentiel positif de ladite tension continue constante est appliqué à ladite grille isolée.

Avantageusement, un dispositif selon l'invention, dans lequel ledit circuit électrique est raccordé par ses bornes à une source de tension alternative monophasée, comporte de plus au moins un deuxième ensemble comprenant un deuxième transistor à effet de champ et une deuxième résistance de source de caractéristiques respectives sensiblement identiques à celles dudit transistor à effet de champ, et de ladite résistance de source, laquelle deuxième résistance de source est reliée par une borne à la source dudit deuxième transistor, lequel deuxième ensemble étant monté tête bêche avec ledit premier ensemble, en série avec celui-ci et avec ladite charge, par la mise au même potentiel des bornes desdites résistances, qui ne sont pas connectées auxdites sources desdits transistors, lequel potentiel étant le potentiel négatif dudit générateur, et en ce qu'il comporte en parallèle sur chacun desdits premier et deuxième ensemble, respectivement une diode (D5, D4), dont le sens de conduction est opposé au sens de conduction respectif desdits transistor.

Avantageusement, on utilise dans ce cas un seul générateur de tension continue constante.

Préférentiellement, dans un dispositif selon l'invention, les rapports respectifs entre lesdites résistances de source et les résistances internes desdits transistors au voisinage de leurs points de transition, sont compris entre 0,1 et 10 et, de préférence, compris entre 0,5 et 2.

Avantageusement, un dispositif selon l'invention comporte, en outre au moins deux résistances de protection respective desdits transistor, chacune desdites résistances étant connectée entre le drain et la source desdits transistors.

Préférentiellement, dans un dispositif selon l'invention, les rapports respectifs entre lesdites résistances de protection et les résistances internes desdits transistors au voisinage de leurs points de transition sont compris entre 10 et 1000 et, de préférence compris entre 50 et 250.

Avantageusement, ladite tension continue constante a une valeur telle que la tension grille source dudit MOSFET est toujours maintenue à une valeur supérieure à 0, de sorte que ledit MOSFET n'est jamais bloqué.

Un avantage de l'invention est de procurer un dispositif très simple, économique, de limitation des surintensités dans le circuit électrique alimentant une charge et dans la charge elle-même.

Un résultat très important de l'invention est de permettre de dimensionner la plupart des composants des circuits électriques, des éléments de protection de ces circuits, pour une intensité très proche de l'intensité nominale absorbée par ladite charge, et permet donc des économies très importantes pour le constructeur, l'installateur et l'utilisateur de ces appareils électriques.

Un autre avantage important d'un dispositif selon l'invention est de disposer d'un ensemble très compact, consommant très peu d'énergie, et qui est susceptible d'être intégré dans tout appareil domestique ou industriel.

La description ci-après, qui se réfère aux figures annexées, explicite, sans aucun caractère limitatif, des modes de réalisation de dispositifs selon l'invention.

La figure 1 est un schéma de principe de base d'un dispositif selon l'invention.

La figure 2 montre les conditions préférentielles de fonctionnement d'un transistor dans un dispositif selon l'invention.

La figure 3 représente un montage complet d'un mode particulier de réalisation d'un dispositif selon l'invention.

Sur ces figures, les éléments repérés par les mêmes numéros, sont invariants.

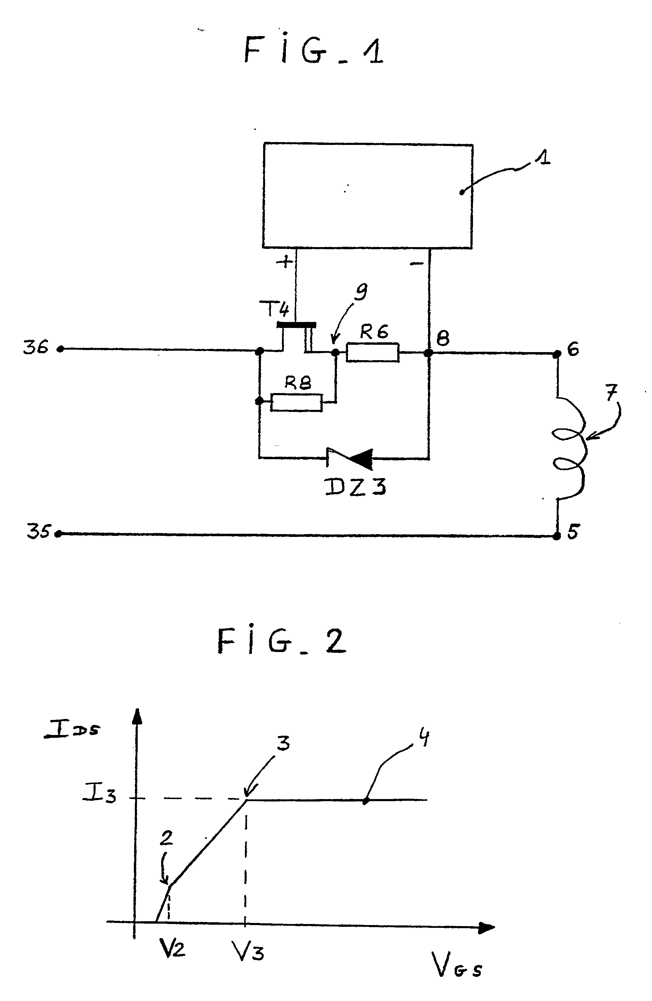

Sur la figure 1, on a représenté un schéma de principe d'un dispositif selon l'invention.

La charge 7, qui peut être par exemple un moteur ou un transformateur, est destinée à être alimentée entre ses bornes 5 et 6 par une source (non représentée), qui délivre une tension entre les bornes 35 et 36, grâce au circuit électrique qui relie les bornes 5 et 35 d'une part, et les bornes 6 et 36 d'autre part.

Le schéma simplifié de la figure 1 pourrait être utilisé dans le cas où ladite source délivrerait entre lesdites bornes 35 et 36, une tension polarisée, c'est-à-dire telle que la différence de potentiel entre la borne 36 et la borne 35, soit toujours positive ou nulle, susceptible de variations brusques.

Dans ce cas, le courant circulerait donc dans ledit circuit électrique de ladite borne 36 à ladite borne 6, de ladite borne 5 à ladite borne 35, et circulerait dans ladite charge 7 de ladite borne 6 à ladite borne 5.

On voit que dans le dispositif selon l'invention, on a inséré en série avec ladite charge 7 un transistor T4 à effet de champ, de type MOS (métal oxyde semi-conducteur) à grille isolée, monté entre les bornes 36 et 9, et une résistance de source R6, dont une borne 9 est reliée à la source dudit transistor, et qui est monté entre les bornes 9 et 8, lequel ensemble transistor et résistance de source est monté en série avec ladite charge 7.

On voit que la conduction dudit transistor T4 est commandée en permanence par la tension positive appliquée à sa grille par un générateur 1 de tension continue et constante, la borne négative dudit générateur étant appliquée à la borne 8 de ladite résistance de source.

Le dispositif comprend également une résistance R8 de protection dudit transistor T4, qui est connectée entre le drain et la source dudit transistor. Il comprend également une diode Zener DZ3 de protection dudit transistor T4 contre les surtensions.

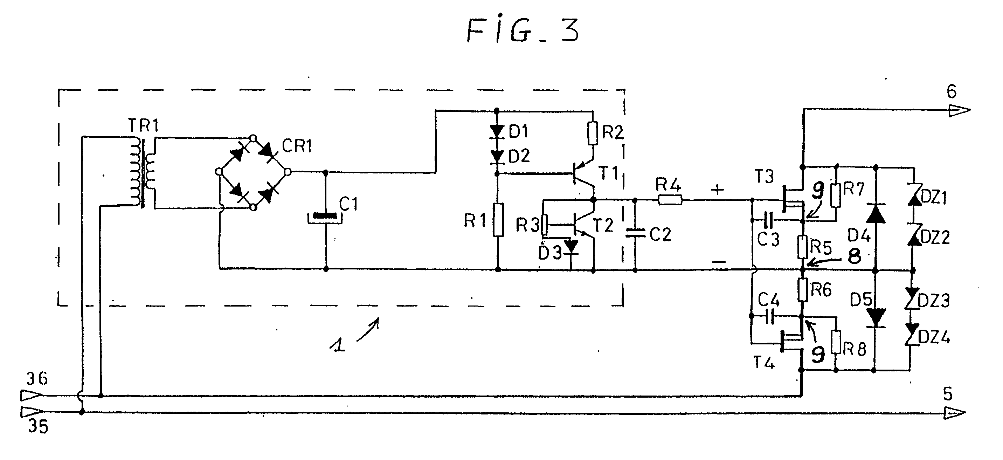

Ledit générateur 1 de tension continue et constante peut être constitué de façon connue par une alimentation indépendante de l'alimentation dudit circuit électrique, ou bien peut être lui-même alimenté par ladite alimentation dudit circuit électrique, tel que représenté figure 3.

Il est à noter que ledit transistor T4 pourrait être constitué par un transistor bipolaire classique, mais cela nécessiterait une commande de conduction en courant, alors que le choix d'un transistor à effet de champ, de type MOS à grille isolée, permet une commande en tension, ce qui simplifie la conception dudit générateur 1.

Le principe fondamental de fonctionnement est le suivant :

En régime normal, le courant d'alimentation de ladite charge 7 passe de la borne 36 de ladite source d'alimentation au drain dudit transistor T4, circule du drain à la source (borne 9) dudit transistor, qui est maintenu conducteur par la tension délivrée par ledit générateur, traverse ladite résistance de source R6, de la borne 9 à la borne 8, puis passe de la borne 8 de ladite résistance à la borne 6 de ladite charge, traverse ladite charge et passe par les bornes 5 puis 35.

Une partie du courant d'alimentation de ladite charge passe par ladite résistance de protection R8 qui est connectée en parallèle avec ledit transistor; cette partie du courant d'alimentation est normalement faible, compte tenu du rapport entre ladite résistance R8 et la résistance interne dudit transistor T4 au voisinage de son point de transition, lequel rapport peut être avantageusement choisi entre 10 et 1000 et, de préférence entre 50 et 250.

Lors d'une augmentation de l'intensité absorbée par ladite charge 7, par exemple due à la variation brutale de la tension délivrée par la source d'alimentation entre les bornes 35 et 36, la tension entre lesdites bornes 8 et 9 de ladite résistance de source augmente; comme ledit générateur 1 maintient une tension constante entre ladite grille dudit transistor T4 et ladite borne 8, il s'ensuit automatiquement une diminution de la tension entre la grille et la source dudit transistor T4. Compte tenu des caractéristiques dudit transistor T4, qui sont rappelées sur la figure 2, ledit transistor passe alors en régime de fonctionnement ohmique, c'est-à-dire que sa résistance interne croît et que l'intensité le traversant entre le drain et la source décroît, ce qui limite donc la surintensité traversant ladite charge; il est évident que simultanément à l'accroissement de la résistance interne dudit transistor, ladite partie du courant d'alimentation qui passe par ladite résistance de protection R8 augmente.

Il est normalement souhaitable de monter ledit transistor et ladite résistance de protection sur un radiateur qui permette d'évacuer la chaleur produite par effet Joule dans ces deux composants lors desdites surintensités.

On voit que ladite résistance de source joue en quelque sorte le rôle de capteur de mesure de surintensité, ledit transistor jouant le rôle d'actionneur, en augmentant automatiquement la résistance du circuit alimentant la charge et limitant ainsi les surintensités.

Ladite diode Zener DZ3 de protection dudit transistor contre les surintensités est choisie de sorte que sa tension de conduction soit inférieure à la tension de claquage dudit transistor, de sorte que lors d'une surtension accidentelle aux bornes dudit transistor, ladite diode Zener devient conductrice et évite la destruction dudit transistor.

Sur la figure 2, on a illustré les conditions préférentielles de fonctionnement d'un transistor dans un dispositif selon l'invention.

L'axe des abscisses repéré par VGS représente la tension entre la grille et la source dudit transistor à effet de champ, de type MOS à grille isolée.

L'axe des ordonnées repéré par IDS représente l'intensité du courant qui circule dans ledit transistor entre son drain et sa source.

Dans ce diagramme, on a représenté schématiquement la courbe caractéristique 4 connue d'un transistor de ce type.

On voit que ladite courbe caractéristique comporte trois zones qui correspondent à trois régimes de fonctionnement dudit transistor :

– dans la zone située à droite du point de transition 3, l'intensité traversant le transistor entre le drain et la source est sensiblement constante, quelle que soit la tension de commande appliquée entre sa grille et sa source, dans la mesure où celle-ci est supérieure à V3, valeur de la tension grille-source correspondant audit point de transition 3 de ladite courbe caractéristique 4; cette zone correspond au régime de fonctionnement saturé du transistor.

– dans la partie de ladite courbe 4 située entre le point 3 de transition et le point 2, une baisse de la tension de commande grille-source entraîne une baisse du courant drain-source traversant ledit transistor, ce qui correspond à une augmentation de sa résistance interne, ce qui fait que dans cette zone de la courbe, on dit que le transistor fonctionne en régime ohmique.

– dans la dernière partie de ladite courbe 4, située à gauche du point 2, pour des tensions de commande inférieures à une tension V2, l'intensité traversant ledit transistor décroît très rapidement lorsque la tension grille-source décroît, jusqu'à prendre une valeur nulle; on parle alors de régime de fonctionnement bloqué dudit transistor.

Il est à noter que les transistors à effet de champ de type MOS à grille isolée sont habituellement utilisés dans les zones de leur courbe caractéristique correspondant au régime bloqué et au régime saturé, notamment dans le cadre de générateur de tension alternative à partir d'une tension continue.

Dans le cas du dispositif selon l'invention, au contraire, on utilise, dans le régime de fonctionnement normal de ladite charge, le transistor au voisinage de son point de transition, lequel point sépare la zone de fonctionnement saturée et la zone de fonctionnement ohmique; de la sorte, une augmentation de l'intensité absorbée par ladite charge provoquant, par l'intermédiaire de ladite résistance de source et de ladite tension constante délivrée par ledit générateur, une baisse de la tension grille-source qui entraîne une baisse du courant traversant le transistor, le point de fonctionnement de celui-ci se déplaçant entre ledit point de transition 3 et ledit point 2, dans ladite zone de fonctionnement ohmique.

Sur la figure 3, on a représenté le schéma électrique d'un mode préférentiel de réalisation d'un dispositif selon l'invention.

Ce montage est particulièrement adapté à toutes les charges qui sont alimentées par une tension alternative monophasée.

Ce montage s'adapte très facilement pour le cas de tension polyphasée, en reproduisant le dispositif décrit ci-après, pour chacune des phases.

On voit que dans ce mode de réalisation ledit générateur de tension continue constante 1 est alimenté par la même source de tension (non représentée) que ladite charge (non représentée).

Le mode de réalisation du générateur 1 de tension continue constante illustré sur cette figure est particulièrement adapté dans le cas où la tension d'alimentation disponible sur les bornes 35 et 36 est susceptible de variations relativement lentes et de grandes amplitudes durant des périodes relativement longues, telles que celles qui se produisent sur certains réseaux de distribution publics ou privés (variations lentes qui sont complètement indépendantes des phénomènes de micro-coupure précédemment cités).

Les composants identiques à ceux de la figure 1 ont les mêmes repères;

On voit sur cette figure que, de façon connue, ledit générateur comporte un transformateur TR1, un pont redresseur à diodes CR1, un générateur de courant constitué par une diode D1, une diode D2, une résistance R1, une résistance R2 et un transistor T1, un générateur de tension stabilisée en température comportant le transistor T2, une résistance R3 et une diode D3, qui est alimentée par ledit générateur de courant et qui délivre ladite tension continue constante.

Ledit générateur de tension constitué par ledit transistor T2, ladite résistance R3 et ladite diode D3, est stabilisé en température grâce à la compensation de la dérive en température des caractéristiques dudit transistor T2 par les effets dûs à la dérive en température des caractéristiques de ladite diode D3; ce montage connu nécessite de monter ces deux composants à proximité immédiate l'un de l'autre, afin qu'ils soient en permanence à la même température, et que la compensation des dérives de leur caractéristiques soit effective.

La résistance ajustable R3 permet de régler en usine la tension continue constante délivrée par ledit générateur 1 aux bornes de la capacité C2, à une valeur telle que, en régime normal, les transistors à effet de champ de type MOS à grille isolée T3 et T4, fonctionnent au voisinage du point de transition de leur courbe caractéristique, de telle sorte que, lorsque l'intensité absorbée par ladite charge dépasse une valeur de seuil, lesdits transistors passent automatiquement en régime de fonctionnement ohmique, leur résistance interne croît, ce qui limite l'augmentation de ladite intensité.

On voit sur cette figure que ledit générateur délivre une tension de commande positive sur la grille desdits transistors T3 et T4 et une tension négative sur la borne 8, qui est commune aux deux résistances de source R5 et R6 qui sont connectées par leur autre borne 9 à la source desdits transistors à effet de champ.

On voit que dans le cas d'alimentation par une source de tension alternative, le dispositif comprend au moins deux ensembles comportant chacun un transistor à effet de champ (T3 et T4 respectivement), une résistance de source (R5 et R6 respectivement).

Chacun de ces ensembles est susceptible d'être court-circuité pendant l'alternance où le transistor à effet de champ ne conduit pas, grâce à une diode D4, D5 respectivement, de sorte que lors de l'alternance de la tension d'alimentation durant laquelle la borne 36 est positive et la borne 35 est négative, le courant permettant l'alimentation de ladite charge, passe successivement par ledit transistor T4, ladite résistance de source R6, ladite diode D4, puis lors de l'alternance suivante, le courant passe successivement par ledit transistor T3, ladite résistance de source R5 et ladite diode D5.

On voit que le dispositif comporte en outre, au moins deux diodes Zener DZ1, DZ3 de protection respective desdits transistors T3, T4 contre les surtensions, chacune desdites diodes Zener DZ1, DZ3 étant montée en parallèle respectivement desdites diodes D4, D5.

Une diode Zener DZ2 (respectivement DZ4) est branchée en série avec ladite diode Zener DZ1 (respectivement DZ3); ceci a uniquement pour but, dans le cadre d'un mode particulier de réalisation du dispositif illustré figure 3, d'ajuster la tension de conduction des ensembles constitués par (DZ1, DZ2) respectivement (DZ3, DZ4) par rapport à la tension de claquage desdits transistors T3, T4, qu'elles protègent respectivement.

Le dispositif comporte également deux résistances R7, R8 de protection desdits transistors T3, T4, chacune desdites résistances R7, R8 étant connectée entre le drain et la source desdits transistors.

Le dispositif comporte en outre, au moins deux capacités C3, C4 de filtrage qui sont respectivement connectées entre la grille et la source desdits transistors T3, T4.

En effet, les temps de réponse des systèmes de limitation de l'intensité principalement constituée des deux ensembles (T3, R5) et (T4, R6) étant très faible (pouvant être de l'ordre de la nano seconde), il est préférable dans les applications usuelles de limiter cette dynamique pouvant constituer une cause d'oscillations indésirables, par l'adjonction de ces capacités qui permettent par exemple d'intégrer lesdites variations d'intensité pendant des durées de l'ordre de la milliseconde.

On voit qu'avantageusement, ledit générateur délivre ladite tension continue et constante aux grilles desdits transistors T3, T4, par l'intermédiaire d'un filtre passe-bas constitué par la résistance R4 et la capacité C2, qui limite le retour de parasites pouvant apparaître dans ledit circuit d'alimentation, vers ledit générateur.

Dans un exemple de réalisation d'un dispositif selon l'invention destiné à limiter le courant d'appel d'un transformateur ferrorésonnant, on a réalisé un dispositif selon l'invention qui permet de limiter les surintensités (dans une charge inductive consommant moins de 600 VA environ) avec les composants ayant les caractéristiques suivantes :

T1 : transistor PNP (Référence MOTOROLA 2N2907 A)

T2 : transistor NPN (Référence MOTOROLA 2N2369)

T3, T4 : transistors MOSFET CANAL N 15A 500V (Référence MOTOROLA MTM 15N 50)

D1, D2 : diodes 1N4148

D4, D5 : diodes 15A 600VZ

DZ1, DZ2, DZ3, DZ4 : diodes ZENER 150V 3,25W

R3 : potentiomètre 10 KOhm

R7, R8 : 33 Ohm, 6W

R5, R6 : 0,33 Ohm, 8W

R4 : 330 Ohm, 0,25W

R2 : 100 Ohm, 0,25W

R1 : 6,8 KOhm, 0,25W

C2, C3, C4 : 680 NF, 63V

C1 : 100µF, 63V.

Dans cet exemple de réalisation, le courant nominal d'alimentation de ladite charge étant de 4 A environ (sous une tension alternative de 220V-50Hz), la chute de tension nominale dans chacune desdites résistances de source (repères R5, R6 de la figure 3) est de 1,32 V ; ladite tension continue constante délivrée par ledit générateur (repère 1 de la figure 3) étant réglée à 8V environ en usine, la tension grille source aux bornes de chacun desdits transistors (repères T3, T4) est maintenue à 6,7V environ, ce qui définit un point de fonctionnement nominal desdits transistors situé (par référence à la figure 2) à droite dudit point (repère 3 de la figure 2) de transition de leur courbe caractéristique : lors d'une augmentation de l'intensité (drain source) d'alimentation traversant lesdits transistors, la chute de tension dans ladite résistance de source augmentant, la tension grille source aux bornes desdits transistors diminue (sans toutefois s'annuler), du fait de ladite tension continue constante, entraînant une augmentation de la résistance interne (drain-source desdits transistors) consécutive à un déplacement du point de fonctionnement desdits transistors sur leur courbe caractéristique (vers la gauche sur la figure 2).

Ledit transformateur ferrorésonnant ayant une impédance ayant une forte ocmposante réactive, l'intensité qu'il absorbe lors de sa mise sous tension peut si l'on ne limite pas l'intensité du courant d'appel dépasser 30 à 35 fois le courant nominal consommé par ce transformateur ; le dispositif de limitation de courant d'appel selon l'invention a été prévu dans ce but pour limiter le courant d'appel lors de la mise sous tension du transformateur ferrorésonnant à une valeur de 15A environ, ce qui représente un courant d'appel sensiblement égal à 4 fois le courant nominal d'alimentation du transformateur ferrorésonnant ; ainsi, lors de la mise sous tension du transformateur ferrorésonnant alimenté par l'intermédiaire du dispositif limiteur de courant selon l'invention, lorsque le courant atteint une valeur de 15A environ, la chute de tension dans lesdites résistances de source est de 4,95V environ ; compte tenu de la valeur réglée en usine (8V) de ladite tension continue constante, la tension grille source aux bornes desdits transistors MOSFET a une valeur sensiblement égale à 3V, ce qui correspond à un point de fonctionnement desdits transistors lorsque ledit ocurant absorbé par ledit transformateur atteint cette valeur de 15A qui se situe au voisinage dudit point de transition de la courbe caractéristique des trransistors, lequel point de fontionnement peut être à gauche (par référence à la figure 2) dudit point de transition, ce qui provoque l'augmentation de la résistance interne dudit transistor et limite ainsi le courant d'appel dudit transformateur ferrorésonnant.

On limite ainsi efficacement, progressivement, et avec un temps de réponse très faible l'intensité dudit courant d'alimentation.

Le domaine technique de l'invention est celui de l'alimentation électrique des appareils domestiques et industriels comportant une charge inductive.


**Revendications**

1. Procédé de limitation des surintensités dans un circuit électrique alimentant une charge (7), caractérisé en ce que :
   – on monte en série avec ladite charge, au moins un transistor (T4) à effet de champ, de type MOS à grille isolée, et au moins une résistance (R6) de source,
   – on applique entre ladite grille isolée dudit transistor et la borne (8) de ladite résistance de source, une tension continue constante, telle que, en régime normal, ledit transistor fonctionne au voisinage du point (3) de transition de sa courbe caractéristique (4), de telle sorte que, lorsque l'intensité absorbée par ladite charge dépasse une valeur de seuil, ledit transistor passe automatiquement en régime de fonctionnement ohmique, sa résistance interne croît, ce qui limite l'augmentation de ladite intensité.

2. Dispositif de limitation des surintensités dans un circuit électrique alimentant une charge (7), caractérisé en ce qu'il comporte, d'une part :
   – au moins un premier ensemble comprenant un transistor (T4) à effet de champ, de type MOS à grille isolée, et une résistance (R6) de source, dont une borne (9) est reliée à la source dudit transistor, lequel ensemble est monté en série avec ladite charge,
   et, d'autre part,
   – un générateur (1) de tension continue et constante, dont la borne positive est connectée à ladite grille isolée dudit transistor et dont la borne négative est connectée à la borne (8) de ladite résistance de source qui n'est pas connectée à ladite source dudit transistor, lequel générateur délivre une tension telle que, en régime normal, ledit transistor fonctionne au voisinage du point (3) de transition de sa courbe caractéristique (4), de telle sorte que, lorsque l'intensité absorbée par ladite charge dépasse une valeur de seuil, ledit transistor passe automatiquement en régime de fonctionnement ohmique, sa résistance interne croît, ce qui limite l'augmentation de ladite intensité.

3. Dispositif selon la revendication 2 dans lequel ledit circuit électrique est raccordé par ses bornes (35, 36) à une source de tension alternative monophasée, caractérisé en ce qu'il comporte de plus au moins un deuxième ensemble comprenant un transistor (T3) et une résistance (R5) de caractéristiques respectives sensiblement identiques à celles dudit transistor (T4) et de ladite résistance (R6), laquelle résistance (R5) est reliée par une borne (9) à la source dudit transistor (T3), lequel deuxième ensemble étant monté tête bêche avec ledit premier ensemble, en série avec celui-ci et avec ladite charge, par la mise au même potentiel des bornes (8) desdites résistance (R5, R6), lequel potentiel étant le potentiel négatif dudit générateur (1), et en ce qu'il comporte en parallèle sur chacun desdits premier et deuxième ensemble, respectivement une diode (D5, D4), dont le sens de conduction est opposé au sens de conduction respectif desdits transistor (T4, T3), de sorte que, pendant une alternance, l'alimentation de ladite charge (7) se fait par ledit transistor (T4), ladite résistance (R6) et ladite diode (D4), et pendant l'alternance suivante, l'alimentation de ladite charge (7) se fait par ledit transistor (T3), ladite résistance (R5) et ladite diode (D5).

4. Dispositif selon la revendication 3, caractérisé en ce qu'il comporte, en outre, au moins deux résistances ( R7, R8 ) de protection respective desdits transistors (T3, T4), chacune desdites résistances (R7, R8) étant connectée entre le drain et la source desdits transistors.

5. Dispositif selon l'une quelconque des revendications 3 à 4, caractérisé en ce qu'il comporte, en outre, au moins deux diodes Zener (DZ1, DZ3) de protection respective desdits transistor (T3, T4) contre les surtensions, chacune desdites diodes Zener (DZ1, DZ3) étant montée en parallèle respectivement desdites diodes (D4, D5).

6. Dispositif selon l'une quelconque des revendications 3 à 5, caractérisé en ce qu'il comporte, en outre, au moins deux capacités (C3, C4) de filtrage, qui sont respectivement connectées entre la grille et la source desdits transistors (T3, T4).

7. Dispositif selon l'une quelconque des revendications 3 à 6, caractérisé en ce que les rapports respectifs entre lesdites résistances de source (R5, R6) et les résistances internes desdits transistors (T3, T4) au voisinage de leurs points de transition, sont compris entre 0,1 et 10 et, de préférence, compris entre 0,5 et 2.

8. Dispositif selon l'une quelconque des revendications 4 à 7, caractérisé en ce que les rapports respectifs entre lesdites résistances de protection (R7, R8) et les résistances internes desdits transistors (T3, T4) au voisinage de leurs points de transition sont compris entre 10 et 1000 et, de préférence compris entre 50 et 250.

9. Dispositif selon l'une quelconque des revendications 2 à 8, caractérisé en ce que ledit générateur (1) est alimenté par la même source de tension que ladite charge et en ce qu'il comporte :
    – un transformateur (TR1),
    – un pont redresseur à diodes (CR1),
    – un générateur de courant (D1, D2, R1, R2, T1),
    – un générateur de tension stabilisé en température (T2, R3, D3), qui est alimenté par ledit générateur de courant et qui délivre ladite tension continue constante.

10. Dispositif selon l'une quelconque des revendications 2 à 9, caractérisé en ce que ledit générateur délivre ladite tension continue et constante par l'intermédiaire d'un filtre passe-bas (R4, C2), qui limite le retour de parasites pouvant apparaître dans ledit circuit d'alimentation, vers ledit générateur.

# FiG_1

# FiG_2

# FIG_3

EP 0 461 054 A1

Office européen
des brevets

# RAPPORT DE RECHERCHE EUROPEENNE

Numero de la demande

EP    91 43 0010

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | FR-A-2564261 (ELECTRICITE DE FRANCE)<br>* page 7, ligne 1 – page 8, ligne 1; figure 1 * | 1-2 | H02H9/02 |
| A | | 3 | |
| Y | DE-A-3535864 (ANT NACHRICHTENTECHNIK)<br>* colonne 2, ligne 25 – colonne 3, ligne 7; figures 1-3 * | 1-2 | |
| A | | 3, 9 | |
| A | DE-A-1538608 (INTERNATIONAL BUSINESS MACHINES CORP.)<br>* page 1, ligne 1 – page 1, ligne 7; figure 2 * | 1, 2 | |
| A | DE-C-3121754 (SIEMENS AG)<br>* figure 1 * | 1, 3 | |
| A | US-A-4404473 (D.A. FOX)<br>* abrégé; figures 1, 3 * | 3, 9 | |

### DOMAINES TECHNIQUES RECHERCHES (Int. Cl.5)

H02H9/02
H03K17/08

Le présent rapport a été établi pour toutes les revendications

| Lieu de la recherche | Date d'achèvement de la recherche | Examinateur |
|---|---|---|
| BERLIN | 13 SEPTEMBRE 1991 | FRITZ S. |